# EUROPEAN PATENT APPLICATION

(11) **EP 3 352 065 A1**
(43) Date of publication of application: **25.07.2018**
(21) Application number: 18150979.5
(22) Date of filing: 10.01.2018
(51) Int. Cl.: G06F 3/044, H03K 17/96, G05B 15/02

(54) **TOUCH SWITCH CAPABLE OF TAKING UP NEW FUNCTION**

(30) Priority: 19.01.2017 TW 106200992 U
(71) Applicant: Philio Technology Corporation, New Taipei City (TW)
(72) Inventor: HUANG, Cheng-Hung, New Taipei City (TW)
(74) Representative: Banse & Steglich Patentanwälte PartmbB

(57) **Abstract**

A touch switch capable of taking up new functions, electrically connected to at least one electrical appliance device, includes a touch display module, a processing unit, and control modules. The touch display module displays a function icon, receives a touch message, and senses ambient temperature, ambient brightness, and human body motion in close vicinity. The processing unit receives the touch message and triggers the electrical appliance device to undergo a switching motion. The control modules each have an operating function corresponding to one of the electrical appliance devices to start the operating function corresponding to the touch message after the processing unit has received the touch message so that the electrical appliance device corresponding to the operating function undergoes the execution motion. The touch switch integrates and controls the electrical appliance devices and enables users to select an appropriate one of the control modules as needed, thereby achieving customization.

## Description

### CROSS REFERENCE

This non-provisional application claims priority from Taiwan Patent Application NO. 106200992 filed on January 19, 2017, the content thereof is incorporated by reference herein.

### BACKGROUND OF THE INVENTION

### FIELD OF THE INVENTION

The present invention relates to switches and, more particularly, to a touch switch capable of taking up new functions, controlling different electrical appliance devices, such as sensing brightness, sensing light color, and switching modes.

### DESCRIPTION OF THE PRIOR ART

A smart home provides household facilities by integrated wiring technologies, network communication technologies, security enhancing technologies, automated control technologies, and audio/video technologies to construct highly efficient residential facilities and household daily affairs management systems, rendering a home safe, convenient, comfortable, artistic, environment-friendly, and energy-efficient.

A smart home embodies the Internet of things (loT) through the internetworking of household apparatuses, such as audio/video apparatuses, lighting systems, curtain control, air conditioning control, security systems, digital theater systems, video servers, film archive systems, network-based electrical appliances, to effectuate electrical appliance control, lighting control, phone remote control, indoor/outdoor remote control, burglary prevention and reporting, surroundings monitoring, heating and ventilation control, IR repeating, and programmable timing control.

A smart home not only functions as a conventional home, but also enables architectural improvements, network communication, information appliances, apparatus automation, effectuates comprehensive information exchange, and even reduces energy costs. Compared with a smart home, a conventional electrical appliance switch poses a safety risk, as it lacks a failure monitoring module and a remote control function, not to mention that an electrical appliance device comes with different electrical appliance switches. Installing a new switch in a renovated house not only undoes the renovation but also causes a waste of materials.

Therefore, it is important to provide an electrical appliance control switch smartly managed to control electrical appliance circuits in a household environment, efficiently prevent a waste of energy, and enable users to perform different switch operations on the electrical appliance circuits with a view to performing respective functions.

### SUMMARY OF THE INVENTION

It is an objective of the present invention to provide a touch switch capable of taking up new functions, controlling different electrical appliance devices, and allowing a user to select an appropriate control module according to the required electrical appliance device, so as to effectuate customization.

In order to achieve the above and other objectives, the present invention provides a touch switch capable of taking up new functions, disposed in a recess on a wall surface and electrically connected to at least one electrical appliance device, the touch switch comprising a touch display module, a processing unit, and a plurality of control modules. The touch display module displays a function icon and receives a touch message on the function icon. The processing unit has a plurality of slots. The processing unit is in electrical communication with the touch display module to receive the touch message and trigger the electrical appliance device to undergo a switching motion. The control modules are disposed in the slots and in electrical communication with the processing unit. The control modules each have an operating function corresponding to one of the electrical appliance devices to trigger the electrical appliance device to undergo an execution motion. After receiving the touch message, the processing unit starts the operating function corresponding to the touch message so that the electrical appliance device corresponding to the operating function undergoes the execution motion.

In an embodiment of the present invention, the touch switch further comprises a connection stand connected to the touch display module through a positioning element. The connection stand comprises a plurality of engaging portions for engaging with and fixing the processing unit and the control modules in place.

In an embodiment of the present invention, the touch display module comprises a display screen, a touch electrode, and a protective plate. The display screen is electrically connected to the touch electrode to display the function icons. The touch electrode is attached to the protective plate to receive the touch message, convert the touch message into an electronic signal, and send the electronic signal to the processing unit.

In an embodiment of the present invention, the touch display module further comprises a sensing unit for sending an electromagnetic wave to detect for a human body motion signal in close vicinity and, after sensing the human body motion signal, automatically trigger the electrical appliance device to undergo the switching motion.

In an embodiment of the present invention, the touch display module further comprises a sensing unit for detecting for ambient brightness automatically and, when the brightness is overly low, triggering automatically the electrical appliance device to undergo the switching motion.

In an embodiment of the present invention, the touch display module further comprises a sensing unit for detecting for an ambient temperature automatically and, when the temperature is overly low, triggering automatically the electrical appliance device to undergo the switching motion.

In an embodiment of the present invention, the processing unit further comprises a wireless transmission module whereby the touch switch is in electrical communication with a mobile device.

### BRIEF DESCRIPTION OF THE DRAWINGS

FIG. 1 is a schematic view of a preferred embodiment of the present invention;
FIG. 2 is a perspective exploded view 1 of a preferred embodiment of the present invention;
FIG. 3 is a perspective exploded view 2 of a preferred embodiment of the present invention;
FIG. 4 is a perspective exploded view 3 of a preferred embodiment of the present invention; and
FIG. 5 is a circuit diagram of a touch switch capable of taking up new functions according to the present invention.

### DETAILED DESCRIPTION OF THE EMBODIMENTS

A touch switch capable of taking up new functions according to a preferred embodiment of the present invention is illustrated by drawings and described below.

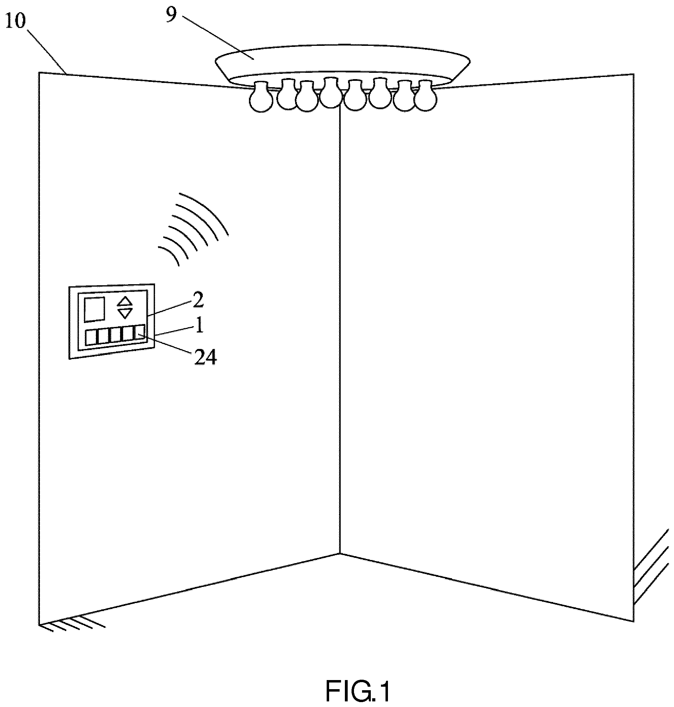

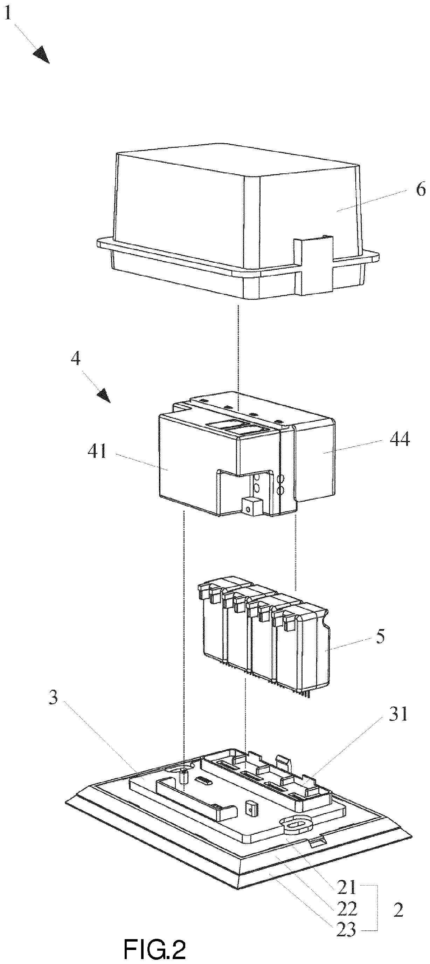

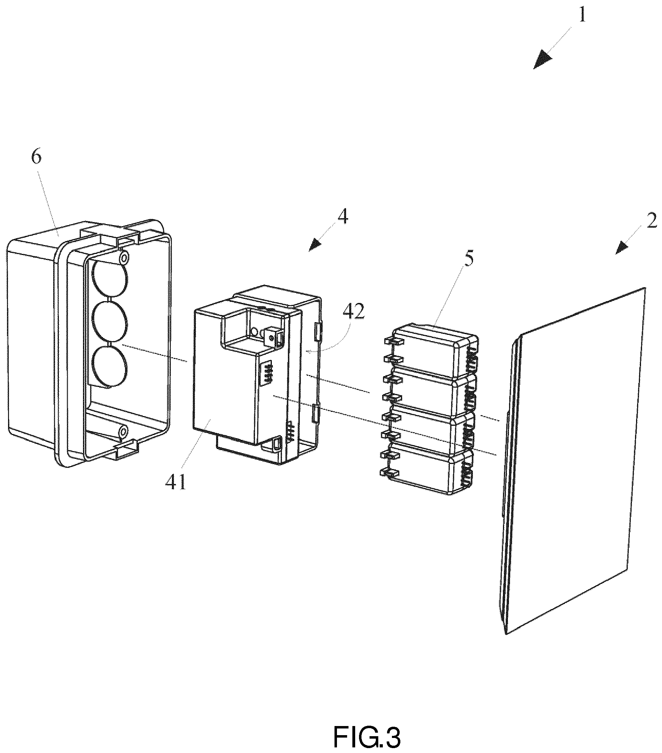

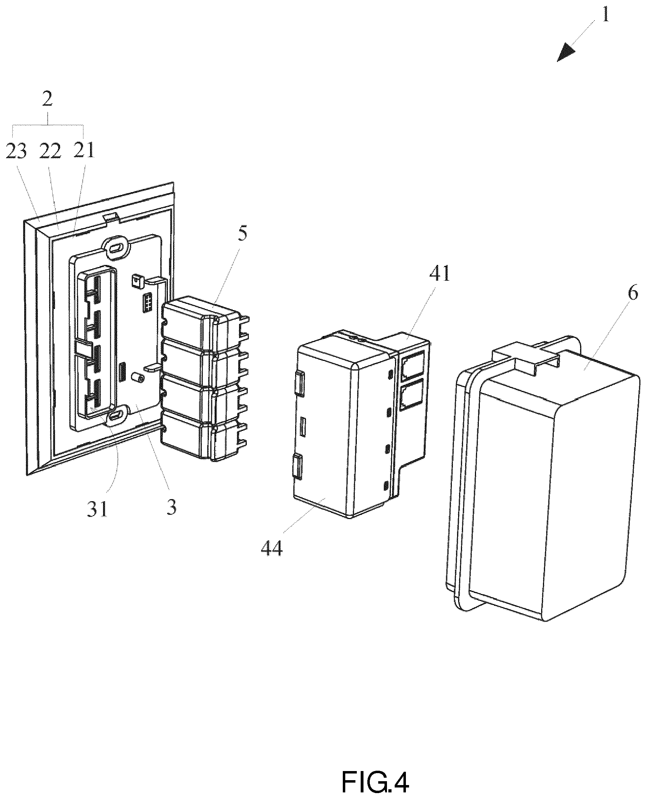

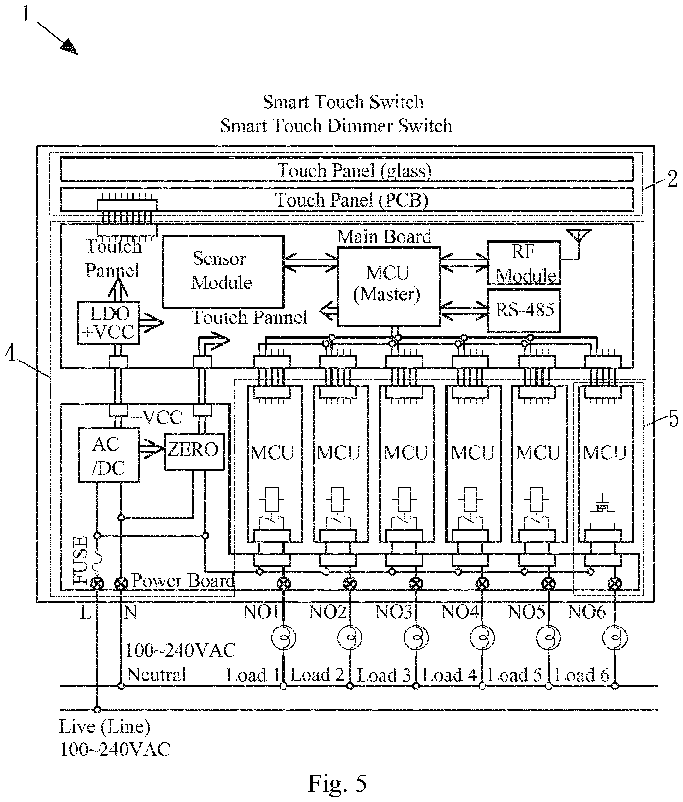

Referring to FIG. 1 through FIG. 5, the present invention provides a touch switch 1 capable of taking up new functions. The touch switch 1 is disposed in a recess (not shown) on a wall surface 10 and adapted to control at least one electrical appliance device 9. The electrical appliance device 9 is an electric lamp, air conditioner, electric heater or electric fan, but the present invention is not limited thereto. The touch switch 1 comprises a touch display module 2, a connection stand 3, a processing unit 4, a plurality of control modules 5, and a casing 6.

The touch display module 2 comprises a display screen 21, a touch electrode 22, and a protective plate 23. The display screen 21 is electrically connected to the touch electrode 22 and displays a plurality of function icons 24 to be touched by a user (not shown) to give a command. The touch electrode 22 is attached to the protective plate 23 and adapted to receive a touch message (not shown) sent when the user touches a corresponding one of the function icons 24, convert the touch message into an electronic signal, and send the electronic signal to the processing unit 4.

In an embodiment of the present invention, the touch display module 2 further comprises a sensing unit (not shown). The sensing unit is capable of motion sensing, light sensing, and temperature sensing. The motion sensing involves detecting for a human body motion signal in close vicinity by an electromagnetic wave generated from the sensing unit and triggering, after sensing the human body motion signal, automatically the electrical appliance device (such as an electric lamp, air conditioner, electric heater or electric fan) to undergo the switching motion. The light sensing is carried out with the sensing unit to automatically detect for ambient brightness and trigger, when the brightness is overly low, automatically the electrical appliance device (such as an electric lamp) to undergo the switching motion. The temperature sensing is carried out with the sensing unit to automatically detect for ambient temperature and trigger, when the temperature is overly low, automatically the electrical appliance device to undergo the switching motion.

The connection stand 3 is connected to the touch display module 2 through a positioning element (not shown). The positioning element is a bolt. The connection stand 3 comprises a plurality of engaging portions 31. The engaging portions 31 engage with and fix the processing unit 4 and the control modules 5 in place.

The processing unit 4 is in electrical communication with the touch display module 2 and adapted to receive the touch message and trigger the electrical appliance device 9 to undergo a switching motion (not shown). The processing unit 4 comprises a circuit board 41 and a shield 44. The circuit board 41 is capable of receiving the touch message, performing voltage transformation, and performing rectification and enables the electrical appliance device 9 to undergo the switching motion. The shield 44 protects the circuit board 41. The shield 44 has a slot 42. The slot 42 receives the control modules 5.

The control modules 5 are disposed in the slot 42 and in electrical communication with the processing unit 4. The control modules 5 each have an operating function (not shown) whereby the electrical appliance device 9 undergoes an execution motion (not shown). After receiving the touch message, the processing unit 4 starts the operating function corresponding to the touch message so that the electrical appliance device 9 corresponding to the operating function undergoes a related execution motion, for example, starting the electrical appliance device, triggering a light bulb to flash, changing the brightness, or regulating temperature for the sake of cooling or heating, but the present invention is not limited thereto.

With the control modules 5 being inserted into the slot 42, the control modules 5 are replaceably in electrical communication with the processing unit 4. The user can change the control modules 5 as needed, so as to effectuate customization.

The casing 6 is connected to the touch display module 2. The casing 6 has therein a receiving space for containing and protecting the connection stand 3, the processing unit 4, and the control modules 5.

In an embodiment of the present invention, the processing unit 4 further comprises a wireless transmission module (not shown). The touch switch 1 is in electrical communication with a gateway (not shown) through the wireless transmission module by Bluetooth connection, a wireless network, or a beacon sensor, but the present invention is not limited thereto. The gateway is in electrical communication with a mobile device (not shown) through the Internet so that the user can remotely control the touch switch 1 with the mobile device to effectuate a smart home.

The present invention provides a touch switch capable of taking up new functions. The constituent components of the touch switch and technical features thereof are clearly, completely described above to allow persons skilled in the art to understand the advantages of the present invention as follows:
1. The present invention provides a touch switch capable of taking up new functions. The control modules of the touch switch can perform different electrical appliance control functions.
2. Users can change the control modules as needed, so as to effectuate customization.
3. The touch switch is capable of motion sensing, light sensing, and temperature sensing to sense ambient changes in close vicinity and automatically start electrical appliance devices, so as to effectuate a smart home.

Although the present invention is disclosed above by feasible preferred embodiments, the preferred embodiments are not restrictive of the claims of the present invention. Equivalent implementation and changes made by persons skilled in the art to the preferred embodiments without departing from the spirit of the present invention must be deemed falling within the scope of the present invention.

## Claims

1. A touch switch capable of taking up new functions, disposed in a recess on a wall surface and electrically connected to at least one electrical appliance device, the touch switch comprising:
a touch display module for displaying a function icon and receiving a touch message on the function icon;
a processing unit having a plurality of slots and being in electrical communication with the touch display module to receive the touch message and trigger the electrical appliance device to undergo a switching motion; and
a plurality of control modules disposed in the slots and being in electrical communication with the processing unit, wherein the control modules each have an operating function corresponding to one of the electrical appliance devices to trigger the electrical appliance device to undergo an execution motion,
wherein, after receiving the touch message, the processing unit starts the operating function corresponding to the touch message so that the electrical appliance device corresponding to the operating function undergoes the execution motion.

2. The touch switch capable of taking up new functions in accordance with claim 1, wherein the touch switch further comprises a connection stand connected to the touch display module through a positioning element.

3. The touch switch capable of taking up new functions in accordance with claim 2, wherein the connection stand comprises a plurality of engaging portions for engaging with and fixing the processing unit and the control modules in place.

4. The touch switch capable of taking up new functions in accordance with claim 1, wherein the processing unit comprises a circuit board capable of receiving the touch message, performing voltage transformation, and performing rectification.

5. The touch switch capable of taking up new functions in accordance with claim 1, wherein the touch display module comprises a display screen, a touch electrode, and a protective plate, with the display screen electrically connected to the touch electrode to display the function icons, and the touch electrode is attached to the protective plate to receive the touch message, convert the touch message into an electronic signal, and send the electronic signal to the processing unit.

6. The touch switch capable of taking up new functions in accordance with claim 1, wherein the touch display module further comprises a sensing unit for sending an electromagnetic wave to detect for a human body motion signal in close vicinity and, after sensing the human body motion signal, automatically trigger the electrical appliance device to undergo the switching motion.

7. The touch switch capable of taking up new functions in accordance with claim 1, wherein the touch display module further comprises a sensing unit for detecting for ambient brightness automatically and, when the brightness is overly low, triggering automatically the electrical appliance device to undergo the switching motion.

8. The touch switch capable of taking up new functions in accordance with claim 1, wherein the touch display module further comprises a sensing unit for detecting for an ambient temperature automatically and, when the temperature is overly low, triggering automatically the electrical appliance device to undergo the switching motion.

9. The touch switch capable of taking up new functions in accordance with claim 1, wherein the processing unit further comprises a wireless transmission module whereby the touch switch is in electrical communication with a mobile device.

10. The touch switch capable of taking up new functions in accordance with claim 1, wherein the control modules are replaceably in electrical communication with the processing unit.
